# FASCICULE DE BREVET EUROPEEN

(11) **EP 2 155 923 B1**
(45) Date de publication et mention de la délivrance du brevet: **25.04.2018**
(21) Numéro de dépôt: 08736616.7
(22) Date de dépôt: 29.04.2008
(51) Int. Cl.: C23C 16/06, C23C 18/12, C30B 7/10, C30B 25/00, C30B 29/60

(54) **PROCEDE ET DISPOSITIF DE PREPARATION D'UN REVETEMENT MULTICOUCHE SUR UN SUBSTRAT**
VERFAHREN UND VORRICHTUNG ZUR HERSTELLUNG EINES MEHRSCHICHTIGEN ÜBERZUGS AUF EINEM SUBSTRAT
METHOD AND DEVICE FOR PREPARING A MULTILAYERED COATING ON A SUBSTRATE

(30) Priorité: 02.05.2007 FR 0754815
(43) Date de publication de la demande: 24.02.2010
(73) Titulaire: Commissariat à l'Énergie Atomique et aux Énergies Alternatives, 75015 Paris (FR)
(72) Inventeur: RUIZ, Jean-Christophe, F-30290 Laudun l'Ardoise (FR); FOURNEL, Bruno, F-30200 Venejan (FR); THOLLON, Stéphanie, F-33770 Salles (FR); DONET, Sébastien, F-38112 Meaudre (FR)
(74) Mandataire: Ilgart, Jean-Christophe
(86) Numéro de dépôt international: PCT/EP2008/055208
(87) Numéro de publication internationale: WO 2008/135444

(56) Documents cités:
- US-A1- 2002 015 797
- US-A1- 2004 137 726
- EDWARDS H K ET AL: "Hydrothermally synthesised Fe2O3 nanoparticles as catalyst precursors for the CVD production of graphitic nanofibres" JOURNAL OF PHYSICS: CONFERENCE SERIES, INSTITUTE OF PHYSICS PUBLISHING, BRISTOL, GB, vol. 26, no. 1, 22 février 2006 (2006-02-22), pages 195-198, XP020109206 ISSN: 1742-6596

## Description

### DOMAINE TECHNIQUE

L'invention a trait à un procédé de préparation d'un revêtement multicouche, à plusieurs couches sur un substrat, ces couches ou films peuvent être des couches, films, continus ou discontinus. Il s'agit notamment de couches minces.

L'invention a également trait à un dispositif pour la mise en oeuvre de ce procédé.

Ce procédé et ce dispositif permettent notamment de préparer des revêtements multicouches ou des hétérostructures pour des systèmes catalytiques.

Une première technique permettant le dépôt de couches minces continues, ou discontinues met en oeuvre des fluides supercritiques et le procédé de dépôt chimique en phase vapeur (CVD).

On sait en effet que, d'une part, l'utilisation des fluides supercritiques a été développée dans le cadre de l'élaboration de matériaux, en particulier pour la synthèse de couches minces et de nanoparticules d'oxydes métalliques. L'élaboration de matériaux en milieu supercritique apparaît comme une alternative à de nombreuses méthodes traditionnelles telles que le broyage de poudres, l'atomisation, les procédés sol-gel, etc... L'utilisation de ces fluides permet de contrôler la morphologie des poudres et d'abaisser la température de synthèse. De meilleures performances catalytiques ont été obtenues avec les matériaux préparés par un procédé mettant en oeuvre un fluide supercritique et sont attribuées à la diminution de la taille des particules comparée à celle obtenue par des procédés classiques du type solide-solide.

Les particules sous forme de poudre sont généralement traitées, par exemple frittées, pour élaborer un matériau présentant une continuité dimensionnelle. Les fluides supercritiques, utilisés comme milieux réactionnels permettent d'obtenir des poudres de faibles dimensions qui se présentent le plus souvent sous forme d'agglomérats submicroniques sphériques, d'une taille généralement de 100 à 600 nm, composés d'une sous structure constituée de cristallites nanométriques d'une taille inférieure à 30 nm qui une fois frittées présentent de bonnes propriétés d'usage [1].

L'imprégnation en milieu supercritique réalisée à partir de précurseurs organométalliques est un procédé d'élaboration de couches minces. Les précurseurs sont dissous dans un fluide supercritique puis le mélange est mis en contact avec le substrat. La détente de ce mélange provoque la précipitation du composé sur le substrat. Des films de silice ou d'oxydes mixtes d'yttrium, baryum et cuivre [2] ont été ainsi réalisés. Cette technologie permet grâce aux propriétés de transport du fluide supercritique, de recouvrir des pièces macroporeuses de géométries très complexes telles que des mousses céramiques, des monolithes de type nid d'abeille, etc... Le dépôt en surface et à l'intérieur de la structure macroporeuse est très homogène non seulement du point de vue de la structure, de la répartition, mais également en épaisseur. Il s'agit d'un dépôt (dit « wash-coat » en anglais) qui se présente sous la forme d'un film continu et qui peut être composé d'oxydes simples ou mixtes tels que TiO₂, ZrO₂, CeO₂, BaO, Al₂O₃, ..., lui donnant un caractère acide ou basique suivant l'application catalytique envisagée. Les cristallites d'une taille généralement inférieure à 30 nm, sont synthétisées en milieu supercritique « SC » et déposées sous forme de film homogène continu sur un support macroporeux. Ces systèmes catalytiques ont une grande surface spécifique et sont souvent performants.

Le document [3] (US-A-4 916 108) décrit un procédé de préparation de catalyseurs métalliques supportés ayant une activité accrue.

Ce procédé consiste :
- à dissoudre un sel de métal catalytique tel que le nickel, le fer, le cuivre, le cobalt, et les métaux précieux dans un fluide supercritique à une température et une pression au-dessus de la température critique et de la pression critique du fluide, pour former une solution du sel de métal catalytique dans le fluide supercritique ;
- à mettre en contact, par exemple par immersion, un support poreux de surface spécifique élevée notamment en céramique, telle que l'alumine ou la zircone, avec la solution du sel de métal catalytique dans le fluide supercritique ;
- à maintenir la solution du sel de métal catalytique dans le fluide supercritique auxdites pression et température critiques pendant la durée nécessaire pour que la solution de métal catalytique dans le fluide supercritique pénètre substantiellement dans toute la surface spécifique dudit support ; et
- à abaisser soit la température, soit la pression de ladite solution en dessous de la température critique du fluide pour déposer un film du sel de métal catalytique sur les surfaces dudit support poreux et pour transformer le fluide supercritique en un gaz récupérable.

Il est possible de chauffer le support poreux contenant un sel métallique dans une atmosphère réductrice pour transformer ledit film de sel métallique en un film de métal pur. Il est également possible de calciner le support poreux contenant le sel métallique pour transformer le sel métallique en oxyde de métal.

Dans ce procédé, le support poreux de surface spécifique élevée est préparé par exemple par un procédé de coulée qui n'est pas décrit en détail.

Le procédé décrit dans ce document comprend au moins deux étapes distinctes séparées pour préparer le catalyseur métallique supporté, à savoir tout d'abord une étape de préparation du support qui est fabriqué par exemple par coulée, ensuite une étape d'imprégnation dudit support réalisée en milieu supercritique, puis éventuellement une étape de réduction en atmosphère réductrice.

Ces étapes sont réalisées en des emplacements, dans des appareils distincts, différents, l'étape impliquant un fluide supercritique étant notamment mise en oeuvre dans une enceinte ou autoclave fermée, chauffée sous pression. De nombreuses manipulations, opérations de transfert, du support entre différents appareils opérant dans des conditions et selon des principes fondamentalement différents sont donc nécessaires pour obtenir le catalyseur supporté final.

Il est à noter que dans ce document c'est la préparation du catalyseur métallique supporté et non celle du support en oxyde qui met en jeu un fluide supercritique.

On connaît par ailleurs en tant que procédé de dépôt de couches minces métalliques, continues ou discontinues ou de nanoparticules dispersées, le procédé de dépôt chimique en phase vapeur (« Chemical Vapour Déposition » en anglais) qui a notamment permis la préparation de nanomatériaux catalytiques performants, comme cela est décrit par exemple dans le document [4] qui décrit la préparation de nanoparticules de rhodium d'une taille de 1 à 5 nm dispersées sur un support par CVD en lit fluidisé. Le support des nanoparticules est préparé dans une étape séparée, distincte de celle de dépôt des particules, et dans un appareil différent.

Il ressort de ce qui précède qu'il existe notamment un besoin pour un procédé de préparation d'un substrat comprenant :
- un support solide ;
- un film homogène et continu d'un ou plusieurs oxydes de métal sur ledit support solide ;
- et des particules d'un ou plusieurs métal (métaux) ou alliage(s) de métaux formant un film continu ou discontinu ou dispersés sur ledit film homogène et continu d'un ou plusieurs oxydes ;
qui soit entre autres simple, fiable, qui comporte un nombre limité d'étapes et de réactifs, qui mette en oeuvre un nombre limité d'appareils, qui soit propre et peu polluant et qui s'adapte facilement à des supports de géométries complexes.

Le but de la présente invention est de fournir un procédé qui réponde entre autres à ce besoin.

Le but de la présente invention est encore de fournir un tel procédé qui ne présente pas les inconvénients, défauts et désavantages des procédés de l'art antérieur.

Ce but et d'autres encore, sont atteints, conformément à l'invention par un procédé de préparation d'un substrat comprenant un support solide et plusieurs couches sur ledit support ;
- au moins une couche étant constituée par un film homogène et continu de particules d'un ou plusieurs oxyde(s) de métal, ou par des particules d'un ou plusieurs oxyde(s) de métal dispersées de manière homogène, sur le support ou sur une couche sous-jacente ;
- au moins une couche étant constituée par un film continu ou discontinu d'un ou plusieurs métal (métaux) ou d'un ou plusieurs alliage(s) de métaux, ou par des nanoparticules dispersées d'un ou plusieurs métal (métaux) ou d'un ou plusieurs alliage(s) de métaux, sur le support ou sur une couche sous jacente ;
ledit procédé comprenant les étapes suivantes :
a) - on imprègne le support solide ou une couche sous-jacente déjà déposée, chauffé, avec une solution de précurseurs du ou des oxyde (s) de métal dans un fluide supercritique, et on dépose un film homogène et continu des particules d'un ou plusieurs oxyde(s) de métal, ou des particules d'un ou plusieurs oxyde(s) de métal dispersées de manière homogène, sur le support ou sur la couche sous jacente ;
b) - on dépose un film continu ou discontinu d'un ou plusieurs métal (métaux) ou d'un ou plusieurs alliage(s) de métaux, ou des nanoparticules dispersées d'un ou plusieurs métal (métaux) ou d'un ou plusieurs alliage(s) de métaux sur le support ou sur une couche sous-jacente, par dépôt chimique en phase vapeur CVD, à partir d'un ou plusieurs précurseurs ;
les étapes a) et b) étant réalisées dans la même enceinte, même réacteur.

On peut réaliser, à partir du support successivement une étape a) puis une étape b) ou on peut réaliser successivement à partir du support une étape b) puis une étape a).

Chacune des étapes a) et b) ou la succession des étapes a) et b) ou b) et a) peut être répétée par exemple de 1 à 10 fois.

Une étape de synthèse organique peut être réalisée après une étape a) et/ou une étape b).

Dans une forme de réalisation préférée du procédé selon l'invention, on prépare un substrat comprenant :
- un support solide ,
- un film homogène et continu d'un ou plusieurs oxyde(s) de métal (métaux) sur ledit support ;
- des nanoparticules dispersées ou un film continu ou discontinu, d'un ou plusieurs métal (métaux) ou d'un ou plusieurs alliage (s) de métaux, sur ledit film homogène et continu ;
ledit procédé comprenant les étapes successives suivantes :
a) - on imprègne le support solide chauffé avec une solution de précurseurs du ou des oxyde(s) de métal (métaux) dans un fluide supercritique et on dépose le film homogène et continu d'un ou plusieurs oxyde(s) de métal (métaux) sur ledit support ;
b) - on dépose les nanoparticules dispersées ou bien un film continu ou discontinu d'un ou plusieurs métaux ou d'un ou plusieurs alliage(s) de métaux sur ledit film homogène et continu, par dépôt chimique en phase vapeur CVD, à partir d'un ou plusieurs précurseurs ;
les étapes a) et b) étant réalisées dans la même enceinte, même réacteur.

Une étape de synthèse organique peut en outre être réalisée entre les étapes a) et b) et/ou après la succession des étapes a) et b) de ce mode de réalisation préféré.

Le procédé selon l'invention peut être défini comme un procédé couplant deux technologies à savoir d'une part l'imprégnation en milieu supercritique (SC) et d'autre part le dépôt chimique en phase vapeur (CVD).

Le couplage, l'association des procédés d'imprégnation en milieu supercritique et de dépôt chimique en phase vapeur dans un seul et même réacteur, enceinte, pour préparer un substrat tel que défini ci-dessus n'a jamais été décrit, ni suggéré dans l'art antérieur.

Uniquement des procédés d'imprégnation d'un support par des sels métalliques en milieu supercritique seuls ou des procédés de dépôt par CVD seuls ont été décrits.

Du fait que le procédé est réalisé dans un seul et même réacteur, le procédé se trouve considérablement simplifié et ne nécessite plus aucun transfert ou manipulation du support d'un appareil à un autre appareil. La durée du procédé et le coût de celui-ci se trouvent fortement réduits de même que la taille de l'installation pour le mettre en oeuvre.

On peut dire que le procédé selon l'invention permet une réelle amélioration du point de vue de la manipulation des substrats catalytiques, couches minces continues et discontinues déposées sur un substrat notamment macroporeux et de leur stabilisation en vue de leur intégration. En effet, le traitement thermique éventuel de stabilisation du substrat peut être aussi réalisé in-situ dans le même réacteur.

Le procédé selon l'invention possède les avantages des procédés respectifs d'imprégnation en milieu supercritique et de dépôt chimique en phase vapeur sans en présenter aucun des inconvénients et il présente encore d'autres avantages résultant d'un véritable effet synergique dû à la combinaison des deux procédés.

En ce qui concerne l'étape d'imprégnation en milieu supercritique, elle présente les avantages déjà mentionnés plus haut dans la présente description.

En outre, au cours de cette étape, les propriétés de transport particulières des fluides en phase supercritique permettent une imprégnation efficace d'une matrice ou support solide, de géométrie simple ou complexe, qu'il soit dense ou macroporeux tel qu'un support filtrant pour la catalyse.

Ces propriétés du fluide SC conduisent à un dépôt de couche active homogène non seulement du point de vue de l'épaisseur, de la dispersion des particules déposées, mais également de la structure. L'imprégnation des parois filtrantes en profondeur d'un support catalytique favorise l'échange en volume et permet d'optimiser la surface spécifique.

En ce qui concerne l'étape de dépôt de nanoparticules de métal par dépôt chimique en phase vapeur CVD, elle présente tous les avantages classiquement présentés par le procédé CVD, qui est une technologie de premier choix par rapport à des procédés tels que l'imprégnation classique par voie liquide ou l'électrodéposition : en effet, la technologie de CVD permet le recouvrement de pièces de géométries complexes telles que les supports catalytiques (mousses, nids d'abeille, céramiques, zéolithes, ...) avec des équipements ne nécessitant pas des domaines de vide poussé, à savoir de la pression atmosphérique à la centaine de Pascal, ce qui en fait un procédé facilement industrialisable. De plus, pour ce qui est du respect de l'environnement et en particulier de l'air et des eaux, la technologie de CVD est une technologie « propre » au contraire des procédés de synthèse polluants tels que l'électrodéposition.

En outre, lors de l'étape de dépôt par CVD de nanoparticules, la maîtrise des conditions opératoires permet de moduler la morphologie, la taille, la concentration et la dispersion des nanoparticules par exemple de catalyseurs et d'accéder ainsi notamment à la synthèse de particules de taille nanométrique (<20 nm) très finement dispersées (à savoir dont la distance inter-particulaire est généralement inférieure à 50 nm).

Ainsi l'association de ces deux technologies de SC et de CVD permet d'améliorer considérablement la capacité d'une part de localiser les métaux catalyseurs dans le volume des pièces et d'autre part de les disperser à l'échelle nanométrique, ce qui permet un abaissement significatif du taux de chargement en métaux catalyseurs et donc du coût des dispositifs surtout pour ceux utilisant des métaux nobles.

Aussi bien la technologie de dépôt chimique en phase vapeur que la technologie d'imprégnation en milieu supercritique sont des technologies dites propres car elles utilisent très peu ou pas de solvants organiques et permettent de récupérer des produits purs et secs qui peuvent ensuite dans certains cas être recyclés. De ce fait, le procédé selon l'invention qui associe ces deux technologies propres est également un procédé propre, peu polluant.

Les deux technologies associées dans le procédé selon l'invention sont complémentaires et le procédé selon l'invention présente de ce fait un certain nombre d'avantages surprenants découlant de l'association des deux technologies qui vont au-delà des simples avantages présentés indépendamment pour chacune desdites technologies.

En particulier, le procédé selon l'invention permet de déposer de manière très sélective des particules nanométriques (par CVD), sur un film homogène continu de grande surface spécifique (préparé par Fluide Supercritique ou FSC). Ces technologies sont peu contraignantes en terme de recouvrement des géométries complexes tels que les supports utilisés dans le domaine du traitement des effluents gazeux qui se présentent notamment sous la forme de mousses ou nids d'abeille céramiques.

Cela signifie que le procédé selon l'invention peut être mis en oeuvre facilement avec toutes sortes de supports quelle que soit leur géométrie même très complexe, bidimensionnelle ou tridimensionnelle.

L'association de ces deux technologies permet notamment de déposer des systèmes catalytiques complets au sein de structures complexes en surface (2D) ou en volume (3D).

Ces catalyseurs se présentent par exemple sous la forme de films minces continus et homogènes et/ou de particules de taille nanométrique par exemple de 1 à 400 nm de diamètre bien dispersées en surface d'un support dense ou poreux.

Enfin, un des avantages essentiels du procédé selon l'invention, outre sa mise en oeuvre dans un seul et même réacteur est l'utilisation au cours de chacune des étapes, d'imprégnation par un fluide supercritique ou de dépôt de nanoparticules par CVD, de précurseurs organométalliques ou de sels métalliques qui peuvent être avantageusement identiques, ce qui simplifie grandement les dispositifs à prévoir pour le stockage, l'acheminement et l'introduction de ces précurseurs dans le réacteur.

En d'autres termes, la différence entre les procédés classiques notamment de dépôt de catalyseurs et le procédé de la présente invention est notamment le couplage de deux procédés utilisant de préférence les mêmes précurseurs organo-métalliques ou sels métalliques et permettant l'élaboration d'un « wash-coat » puis la dispersion de nanoparticules de métaux nobles ou non nobles dans un seul et même réacteur.

Le procédé de la présente invention présente également l'avantage qu'il permet, dans une seule enceinte, une fabrication de systèmes catalytiques complets trouvant des applications directes dans le domaine du traitement de l'air, par exemple pour le traitement des composés organiques volatils COV, des oxydes d'azote NOx, ou pour la génération d'hydrogène par reformage.

Le support solide peut être un support dense ou un support poreux plus précisément macroporeux.

Par support macroporeux, on entend par exemple des mousses telles que des mousses céramiques d'une porosité de quelques ppi à plusieurs dizaines de ppi (pores par inch), et/ou des supports à structure en nids d'abeilles de quelques cpsi (canaux par pouce carré) à plusieurs centaines de cpsi.

Le support solide peut être constitué par un matériau choisi parmi les céramiques ; les métaux et alliages métalliques tels que l'acier ; les polymères ; les zéolithes ; le silicium ; le verre ; les tissus ; et les matériaux composites comprenant plusieurs des matériaux précités.

Les céramiques sont les matériaux préférés.

Cette ou ces céramiques peuvent être choisies parmi les céramiques oxydes, simples ou mixtes, les nitrures et les carbures. Avantageusement, ces céramiques sont choisies parmi la cordiérite (2 Al₂O₃.2SiO₂.5MgO), le carbure de silicium (SiC), l'alumine/dioxyde de titane (Al₂O₃/TiO₂), l'alumine/zircone (Al₂O₃/ZrO₂), le dioxyde de titane (TiO₂), l'alumine (Al₂O₃), la zircone (ZrO₂), et la silice (SiO₂).

Comme on l'a indiqué plus haut le procédé selon l'invention peut être mis en oeuvre avec des supports à structure géométrique complexe par exemple une structure de type macroporeuse bidimensionnelle ou tridimensionnelle. Par structure géométrique complexe, on entend généralement des supports de formes variées, à porosité et pertes de charge contrôlées.

Par exemple, ces supports peuvent se présenter sous la forme de mousses, nids d'abeilles, tubes poreux, granulés, vermicelles, billes, ou fibres.

Le support pourra par exemple se présenter sous la forme d'un nid d'abeille ou d'une mousse céramique par exemple d'une mousse d'Al₂O₃/TiO₂, ou encore de fibres.

Le ou les oxyde (s) de métal du film homogène et continu ou des particules dispersées de manière homogène peuvent être choisis parmi les oxydes d'aluminium, cérium, baryum, zirconium, titane, vanadium, les oxydes mixtes des métaux précités, les mélanges de ces oxydes et oxydes mixtes, et les zéolithes.

Le film homogène et continu ou les particules dispersées de manière homogène pourra (pourront) par exemple être en Al₂O₃, en CeO₂-ZrO₂, en BaO₂, en une zéolithe, en TiO₂/V₂O₅, en un mélange de Al₂O₃, CeO₂, BaO, ZrO₂.

Lors de l'étape a) le support ou la couche sous jacente (déjà déposée) sur laquelle est déposé le film ou les particules dispersées est généralement chauffé à une température par exemple de 150 à 400°C.

Lors de l'étape a) les précurseurs du ou des oxydes de métal sont généralement choisis parmi les précurseurs organométalliques et les sels métalliques des métaux mentionnés plus haut, métaux dont les oxydes constituent le film homogène et continu ou les particules dispersées de manière homogène préparé(s) lors de l'étape a).

Les précurseurs organométalliques sont choisis généralement parmi les alcoxydes de métaux, les β-dicétonates de métaux et les carboxylates de métaux, les métaux étant ceux dont les oxydes constituent le film ou les particules préparé(s) dans l'étape a).

Le film qui peut être préparé dans l'étape a) est un film homogène et continu à savoir qu'il recouvre totalement la surface du support, quelle que soit la géométrie de celui-ci et qu'il ne laisse aucune surface du support non revêtu même dans les éventuelles cavités, évidement, reliefs, creux de ce support.

Le film qui peut être préparé lors de l'étape a) peut être généralement qualifié de film « mince » dont l'épaisseur est généralement de 50 à 800 nm, de préférence de 80 à 150 nm.

Par fluide supercritique, on entend que le fluide se trouve à une pression supérieure à sa pression critique P_{C} et à une température supérieure à sa température critique T_{C}.

La température et la pression du fluide sont généralement respectivement comprises entre 100 et 600°C et entre 10 et 50 MPa.

Le fluide utilisé peut être choisi, par exemple, parmi le dioxyde de carbone, l'hexafluorure de soufre, l'oxyde nitreux, le protoxyde d'azote, les alcanes légers ayant, par exemple, de 1 à 6 atomes de carbone, tels que le méthane, l'éthane, le propane, le butane, l'isobutane, le pentane, l'hexane, les alcènes de 1 à 5C, comme l'éthylène et le propylène, ainsi que certains liquides organiques, comme le méthanol, l'éthanol, l'isopropanol et le butanol.

On peut bien sûr utiliser tout composé pouvant présenter un état supercritique, et dont l'utilisation reste compatible avec le ou les matériaux constitutifs du support et les précurseurs.

Le dioxyde de carbone est préféré car il présente l'avantage d'une mise en oeuvre relativement facile : il est bon marché, non toxique, ininflammable et possède des conditions critiques facilement accessibles (pression critique : Pc de 7,3 MPa et température critique Tc de 31,1°C).

En outre, le fluide supercritique est choisi pour qu'il assure une excellente solubilisation des précurseurs.

Lors de l'étape a), le dépôt du film est réalisé par un procédé sol-gel et/ou un procédé de décomposition thermique.

Ces procédés sont des procédés bien connus de l'homme du métier dans ce domaine de la technique.

Les procédés sol/gel et/ou les procédés de décomposition thermique sont des procédés mettant en jeu un mécanisme complexe de réactions d'hydrolyse, de polycondensation et de décomposition thermiques des précurseurs organométalliques en milieu fluide supercritique.

En outre, un procédé de synthèse organique peut être réalisé indépendemment et après l'étape a) et/ou l'étape b).

Parmi les procédés de synthèse organique on peut citer à titre d'exemple les procédés de polycondensation interfaciale, la polymérisation en émulsion et la polymérisation en milieu dispersé qui sont utilisés pour l'enrobage de particules métalliques par un polymère.

Avantageusement, à l'issue de l'étape a) et préalablement à l'étape b), on procède à une purge et un nettoyage du réacteur par balayage avec le fluide supercritique du support sur lequel est déposé un film homogène et continu ou des particules dispersées d'un ou plusieurs oxydes de métal.

Le ou les métaux ou alliage (s) de métaux qui sont déposés lors de l'étape b) sont choisis généralement parmi les métaux dits « nobles » des colonnes VIIIB et IB du Tableau périodique, les métaux non nobles à activité catalytique tels que Cu, Ag et Ni, les alliages de ceux-ci entre eux, et les alliages de ceux-ci avec d'autres métaux.

Avantageusement, le métal ou les métaux est(sont) choisi(s) parmi l'argent, le rhodium, le platine, le palladium, l'iridium, le cuivre, le nickel et l'or.

Dans le cas de nanoparticules ou d'un film continu d'un alliage, celui-ci est de préférence choisi parmi les alliages des métaux « nobles » et non nobles des colonnes VIIIB et IB du tableau périodique, tels que Ag, Rh, Pt, Pd, Ir, Cu, Ni et Au entre eux.

On peut ainsi selon l'invention préparer des particules d'alliages binaires de Ag/Rh, des particules d'alliages ternaires tels que Ag/Pt/Rh, ou des particules composites comprenant au moins un métal et au moins un oxyde tel qu'un oxyde de métal alcalin, alcalino terreux ou de terre rare.

Par ailleurs, on peut déposer selon le procédé de l'invention des particules ou un film continu ou discontinu uniquement d'un seul métal tel que Ag, Pt ou Au ou alliage ou bien on peut déposer simultanément plusieurs particules différentes dont chacune est constituée par un métal ou un alliage différent.

Lors de l'étape b) le dépôt peut être réalisé en présence d'un gaz comprenant un gaz réactif oxydant ou un gaz réactif réducteur.

Le gaz peut comprendre plus de 50% en volume, de préférence plus de 70% en volume, de préférence encore 100% en volume d'un gaz réactif oxydant.

Le dépôt se présente alors généralement sous la forme de particules dispersées notamment dans le cas de l'argent, ou d'un film discontinu.

Pour d'autres compositions de gaz, notamment dans le cas de l'argent, le dépôt se présente plutôt, généralement, sous la forme d'un film continu.

Le gaz réactif oxydant peut être choisi parmi l'oxygène, le dioxyde de carbone, l'ozone, le protoxyde d'azote N₂O, et leurs mélanges.

Le gaz réactif réducteur peut être choisi parmi l'hydrogène, l'ammoniac, les vapeurs d'alcool, les hydrocarbures et leurs mélanges.

Le gaz en présence duquel est réalisé le dépôt peut être un mélange du gaz réactif oxydant ou du gaz réactif réducteur et d'un gaz inerte.

Le gaz inerte peut être choisi parmi l'argon, l'azote, l'hélium et leurs mélanges.

Lorsque le gaz est constitué par un mélange d'un gaz oxydant et d'un gaz inerte et que le rapport du débit du gaz oxydant sur le débit du gaz inerte est supérieur à 1 on obtient alors généralement un dépôt de particules, notamment d'argent, dispersées sur le support ou un film discontinu.

On peut utiliser les mêmes précurseurs dans les étapes a) et b).

Dans l'étape b), les précurseurs sont généralement choisis parmi les composés organométalliques tels que les carboxylates de métaux et les β-dicétonates de métaux ; et les sels métalliques tels que les nitrates de métaux.

Le ou les précurseurs peuvent être mis en oeuvre sous la forme d'une solution de ces précurseurs dans un solvant organique.

La concentration du ou des précurseur(s) dans la solution peut être de 0,01 à 0,6 mol/l.

Ce solvant a généralement une température d'évaporation inférieure à la température de décomposition du ou des précurseur(s).

Le solvant est choisi généralement parmi les composés organiques liquides à température ambiante et jusqu'à 200°C dans les conditions normales de pression.

Ainsi, le solvant peut être choisi parmi le mésitylène, le cyclohexane, le xylène, le toluène, le n-octane, l'isopropanol, le tétrahydrofuranne, l'acétylacétone, l'éthanol, le butanol ; l'eau ; et leurs mélanges.

La solution notamment dans le cas où le ou les précurseur(s) est (sont) un précurseur d'argent ou d'un alliage d'argent peut comprendre en outre une amine et/ou un nitrile.

Dans l'étape b), le dépôt est généralement réalisé à une température du support inférieure ou égale à 500°C, de préférence inférieure ou égale à 300°C, de préférence encore de 250 à 290°C.

Dans l'étape b), le dépôt peut être réalisé à pression atmosphérique ou bien sous vide, de préférence à une pression de 300 Pa à 1000 Pa.

La durée du dépôt lors de l'étape b) est généralement de 2 à 90 minutes, de préférence de 5 à 30 minutes.

Le dépôt de l'étape b) peut être réalisé avec assistance plasma.

Selon les conditions dans lesquelles est effectué le dépôt de l'étape b), on peut obtenir un film continu de métal ou d'alliage de métaux ou bien le dépôt est constitué des particules dispersées, discrètes, lesdites particules peuvent avoir une taille de 1 à 400 nm, de préférence de 1 à 100 nm, de préférence encore de 5 à 50 nm et une densité de 10 à 500 µm⁻², de préférence de 50 à 200 µm⁻².

Certaines des particules peuvent se rejoindre pour former un film discontinu, poreux sur la surface du support à savoir de la couche d'oxydes.

Avantageusement à l'issue de l'étape a), on réalise un traitement thermique par exemple à de 400 à 800°C pendant 3 heures pour stabiliser la couche d'oxydes, ou le film continu ou discontinu ou les particules dispersées de métal ou d'alliage de métaux.

L'invention concerne en outre un dispositif pour la mise en oeuvre du procédé selon la revendication 1, comprenant :
- une enceinte ou réacteur dans lequel est placé un support solide ;
- des moyens pour amener un fluide à l'état supercritique ;
- des moyens pour dissoudre un ou plusieurs précurseurs d'oxyde(s) de métal dans le fluide supercritique ;
- des moyens pour amener la solution de précurseurs du ou des oxyde (s) de métal dans le fluide supercritique dans le réacteur, en contact avec le support ou avec une couche déjà déposée ; moyennant quoi on dépose un film homogène et continu ou des particules dispersées de manière homogène d'un ou plusieurs oxyde(s) de métal sur ledit support ou ladite couche ;
- des moyens pour soutirer le fluide supercritique à l'issue du dépôt, à partir du réacteur, le détendre, séparer les précurseurs n'ayant pas réagi du fluide et recycler celui-ci vers le réacteur ;
- des moyens pour amener dans ledit réacteur un gaz contenant un ou plusieurs précurseur(s) d'un ou plusieurs métaux ou alliage de métaux ;
- des moyens pour chauffer le support ou une couche déjà déposée ;
- des moyens pour mettre le réacteur sous vide ou sous pression.

Ce dispositif présente notamment tous les avantages inhérents au procédé qu'il met en oeuvre et déjà décrits ci-dessus. En particulier, il permet d'effectuer dans un seul et même réacteur le dépôt de plusieurs couches par CVD et imprégnation FSC ainsi que les traitements thermiques éventuels.

L'invention va maintenant être décrite de manière plus détaillée dans la description qui suit, donnée à titre illustratif et non limitatif, faite en référence aux dessins joints, dans lesquels :

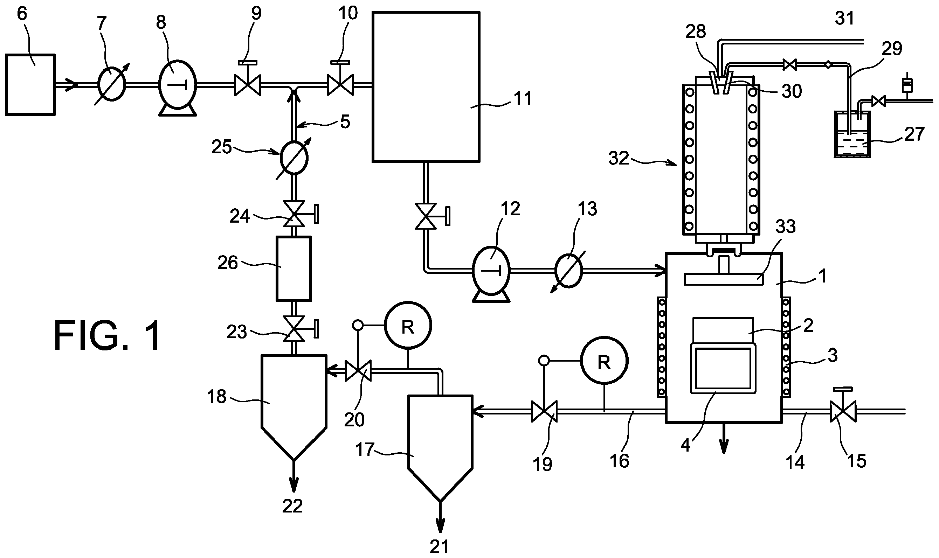

- la figure 1 est un schéma de principe en coupe verticale d'une installation pour la mise en oeuvre du procédé de l'invention ;

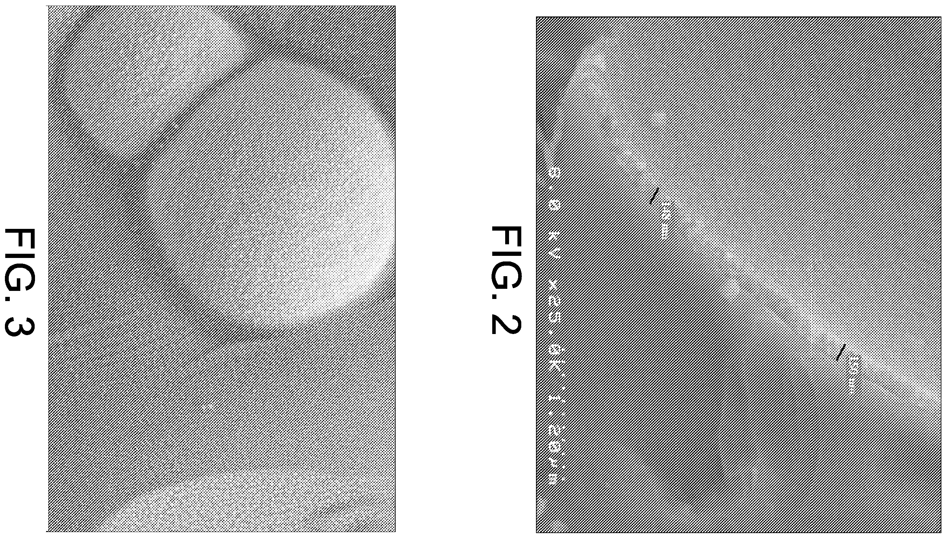

- la figure 2 est une microphotographie réalisée en microscopie électronique à balayage (MEB-FEG) montrant une couche d'oxydes Al₂O₃, CeO₂, BaO, ZrO₂ préparée sur un support céramique poreux constitué d'une mousse d'alumine-zircone 20 ppi (« pores per inch (pouces) ») dans les conditions de l'exemple 1 (Etape 1 du procédé selon l'invention). Le grandissement utilisé est de 25 000. L'échelle représentée sur la figure 2 est de 1,20 µm.

Les repères sombres sur la figure indiquent des épaisseurs de couche de 148 nm et 150 nm.
- la figure 3 est une microphotographie réalisée en microscopie électronique à balayage (MEB-FEG) montrant des nanoparticules de platine, préparées selon la 2ème étape du procédé de l'invention, sur la couche d'oxydes préparée dans l'exemple 1, et dans les conditions de l'exemple 2. Le grandissement utilisé est de 50 000.

L'échelle représentée sur la figure 3 est de 1 µm.

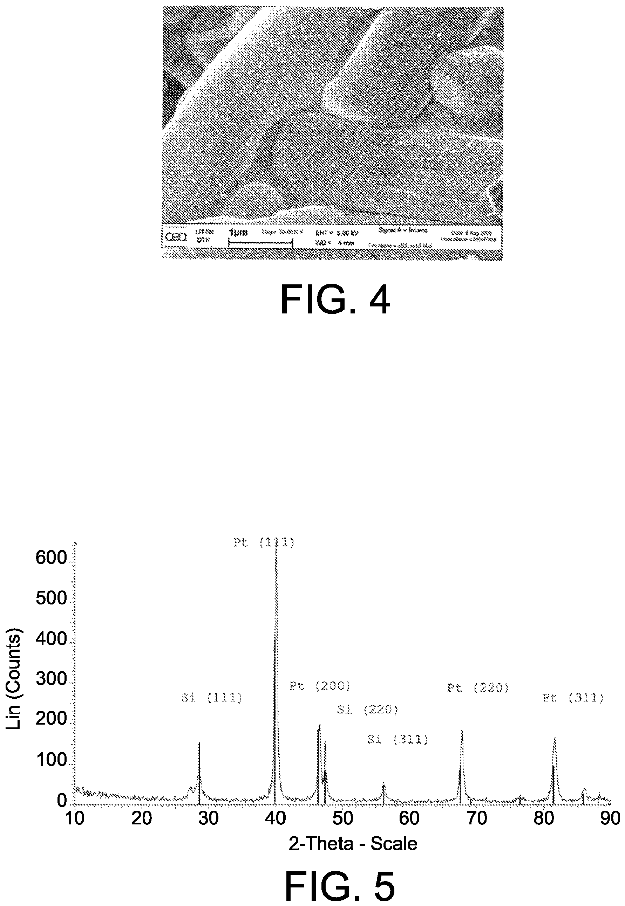

- La figure 4 est une microphotographie réalisée en microscopie électronique à balayage (MEB-FEG) montrant des nanoparticules de platine, préparées selon la seconde étape du procédé selon l'invention, sur la couche d'oxydes préparée dans l'exemple 1, et dans les conditions de l'exemple 2. Le grandissement utilisé est de 50000.

L'échelle représentée sur la figure 4 est de 1 µm.
- La figure 5 est un spectre de diffraction des rayons X du dépôt de nanoparticules de Pt déposées par MOCVD dans l'exemple 2 (Figures 2, 3 et 4).

En abscisse est porté 2θ et en ordonnée est portée l'intensité arbitraire des rayons X.

Il est à noter que dans la description détaillée qui suit on décrira plus particulièrement la forme de réalisation préférée du procédé selon l'invention dans lequel on réalise successivement sur un support solide les étapes a) puis b), et l'installation permettant la mise en oeuvre de cette forme de réalisation préférée. L'homme du métier pourra facilement réaliser les adaptations nécessaire pour inverser, alterner et/ou répéter lesdites étapes a) et b) .

Sur la figure 1, on a représenté le schéma de principe en coupe verticale d'une installation pour la mise en oeuvre du procédé selon l'invention couplant les procédés de dépôt chimique en phase vapeur et de dépôt en milieu supercritique.

Il est bien évident qu'une telle figure ne représente qu'un exemple de réalisation d'une installation et qu'elle n'est donnée qu'à titre illustratif et non limitatif.

L'installation comprend un autoclave, ou réacteur (1) dans lequel se trouve placé le support (2), cet autoclave, réacteur jouant conformément à l'invention le rôle d'enceinte d'imprégnation, dépôt en milieu supercritique, puis le rôle d'enceinte de dépôt par CVD.

Un tel autoclave, réacteur, ou enceinte de dépôt (1) est capable de supporter la pression mise en oeuvre dans le procédé de l'invention dans l'étape supercritique et il est également muni de moyens de chauffage et de régulation de la température sous la forme d'une double enveloppe thermostatée (3), dans laquelle circule un fluide caloporteur adéquat, ou bien des résistances électriques chauffantes.

Le volume de l'autoclave, ou réacteur, (1) est variable, il est fonction notamment du volume du support sur lequel s'effectue les dépôts, il peut être facilement déterminé par l'homme du métier.

L'enceinte, réacteur, reçoit le support (2) ou les supports sur lequel doivent été effectués les dépôts, ces supports sont placés, de préférence, sur un ou plusieurs éléments support(s) ou grille(s) (4).

Le support peut avoir une forme quelconque car le procédé selon l'invention permet le dépôt d'oxydes puis de particules de métaux, par exemple de particules d'argent, même sur des substrats qui présentent une géométrie très complexe. Le support peut être choisi parmi les supports poreux ou parmi les supports denses, non poreux.

Le support peut avoir un état de surface quelconque, il peut être rugueux ou lisse.

La taille du substrat n'est pas limitée, aussi bien des substrats de petite que de grande taille peuvent recevoir un dépôt par le procédé de l'invention.

Le support peut être en un matériau de nature diverse(inorganique, organique ou composite), et même en un matériau relativement sensible à la chaleur grâce aux températures de dépôt relativement faibles utilisées.

Le support peut être par exemple en un matériau tel que défini plus haut.

Sur la figure 1, l'installation représentée ne comporte qu'une seule enceinte, réacteur, autoclave (1), il est bien évident que l'installation peut comprendre plusieurs enceintes, par exemple, de 2 à 10, disposés, par exemple, en série.

L'installation comprend une première partie reliée à l'enceinte de dépôt plus particulièrement destinée à mettre en oeuvre la première étape du procédé selon l'invention qui est effectuée en milieu supercritique.

Ainsi, l'installation selon l'invention, comprend-elle, des moyens pour amener un fluide, tel que du CO₂ à l'état supercritique, et acheminer ce fluide dans l'enceinte.

Sur la figure 1, le fluide, par exemple, du CO₂, en provenance d'une canalisation de recyclage (5), et/ou éventuellement d'un réservoir de stockage et d'appoint, par exemple, de CO₂ (6) (via un condenseur (7), une pompe (8) et une vanne (9), pénètre, par l'intermédiaire d'une vanne (10) dans un réservoir de liquéfaction (11) muni de moyens de régulation de la température (non représentés) par exemple sous la forme d'une double enveloppe thermostatée, dans laquelle circule un fluide caloporteur adéquat.

Ledit fluide, tel que du CO₂, est ainsi liquéfié puis est pompé et comprimé par l'intermédiaire d'une pompe (12), par exemple, une pompe de compression de type à membrane ou à piston ou, par exemple, d'un compresseur vers l'enceinte, réacteur (1).

Avant d'être introduit dans l'extracteur (1), le fluide, par exemple, le CO₂ pompé, est réchauffé dans un échangeur (13), dit échangeur « supercritique », dans lequel il est réchauffé pour se trouver dans des conditions où il est sous la forme d'un fluide dense et sous pression, en particulier, d'un fluide dense supercritique. C'est-à-dire que le fluide, est, dans cet échangeur (13) réchauffé au-delà de sa température critique qui est, par exemple, de 31,1°C, dans le cas du CO₂.

L'introduction des précurseurs se fait directement dans le réacteur après introduction du support. Il est également prévu une canalisation (14) pourvue d'une vanne (15) pour introduire le fluide supercritique et les précurseurs dans l'enceinte (1) si leur mélange se fait dans un réacteur indépendant (non représenté).

A l'issue de l'opération d'imprégnation en milieu supercritique qui est l'étape a) du procédé selon l'invention, un courant de fluide tel que du CO₂, dans lequel sont solubilisés les précurseurs n'ayant pas réagi est évacué de l'enceinte (1) par la canalisation (16) et est ensuite envoyé vers des moyens de séparation reliés à l'autoclave, réacteur (1) et comprenant, par exemple, deux séparateurs de type cyclone (17, 18) reliés en série, chacun d'entre eux étant précédé d'une vanne de détente automatique (19, 20) .

Deux séparateurs de type cyclone (17, 18) ont été représentés sur la figure 1, mais il est bien évident que le nombre, le type et la succession des séparateurs peut varier.

La détente à laquelle est soumis le fluide s'opère à température constante.

Dans chacun des séparateurs (17, 18), se produit une séparation ou démixtion, d'une part, des composés précurseurs n'ayant pas réagi qui sont sous forme de liquide et, d'autre part, d'un gaz, par exemple, du CO₂.

Les composés précurseurs sont soutirés (21, 22), par exemple, à la base des séparateurs, et récupérés, puis éventuellement soumis à de nouvelles opérations de séparation, d'extraction ou de purification, par exemple, centrifugation, décantation ou extraction liquide/liquide, ou détruits.

Le gaz issu de la séparation, tel que du CO₂ est épuré, puis envoyé dans les moyens de recyclage du fluide, qui comprennent, essentiellement, outre des vannes (23, 24), une canalisation (5) et un échangeur « froid » (25) (condenseur, liquéfacteur) par exemple, sous la forme d'une enceinte thermostatée. Le gaz est ensuite dirigé vers la réserve liquide (11) à basse température, maintenue par l'intermédiaire d'un bain réfrigérant qui refroidit et liquéfie le fluide, tel que le CO₂.

Les moyens d'épuration (26) ont été représentés sur la figure 1 par une colonne à reflux ou une colonne à charbon actif (26) placée sur les moyens de recyclage du fluide.

Enfin, l'installation comprend des moyens de régulation (non représentés sauf pour ce qui concerne la régulation des vannes 19, 20), notamment de la pression, dans les différentes parties du procédé, qui comprennent une chaîne de régulation composée de capteurs de pression, de régulateurs et de vannes à aiguille pilotées pneumatiquement.

L'installation comprend par ailleurs une seconde partie reliée à l'enceinte de dépôt (1) et plus particulièrement destinée à mettre en oeuvre la seconde étape du procédé selon l'invention à savoir l'étape de dépôt d'une couche continue ou discontinue d'un métal ou alliage ou de nanoparticules dispersées de métaux ou d'alliages de métaux par dépôt chimique en phase vapeur CVD.

De manière plus précise, pour la mise en oeuvre de la deuxième étape du procédé selon l'invention, la composition généralement sous forme liquide contenant le ou les précurseurs est généralement envoyée tout d'abord dans un dispositif de vaporisation ou vaporisateur.

La composition contenant le ou les précurseurs, se présente de préférence, sous la forme d'une solution du ou des précurseurs dans un solvant, ladite solution comprenant de préférence un nitrile et/ou une amine pour favoriser la dissolution du précurseur dans la solution, en particulier si le précurseur en question est un précurseur de l'argent.

La concentration en volume de l'amine et/ou du nitrile dans la solution est généralement supérieure à 0,1%, de préférence de 0,5 à 10%.

L'amine est généralement choisie parmi les monoamines telles que la n-hexylamine, l'isobutylamine, le disecbutylamine, la triéthylamine, le benzylamine, l'éthanolamine et la diisopropylamine ; les polyamines ; et leurs mélanges.

Le nitrile est généralement choisi parmi l'acétonitrile, le valéronitrile, le benzonitrile et le propionitrile et leurs mélanges.

Le ou lesdits précurseurs sont généralement des composés organométalliques ou des sels de métaux tels que les nitrates de métaux. La solution peut ne contenir qu'un seul précurseur qui est alors, par exemple, un composé organométallique de l'argent. Si la solution contient plusieurs précurseurs alors l'un de ces précurseurs peut être un précurseur d'un premier métal, par exemple un composé organométallique de l'argent, et le ou les autres précurseurs sont des composés organométalliques d'autres métaux différents du premier métal, par exemple différent de l'argent afin de former sur le substrat un alliage de ce premier métal, tel que l'argent et de cet autre métal ou de ces autres métaux.

On a vu plus haut que les précurseurs organométalliques préférés aussi bien de l'argent que des autres métaux sont choisis parmi les alcoxydes, β-dicétonates et les carboxylates de métaux de formule M(O₂CR où M est un métal et R est défini ci-dessous.

Ainsi, les précurseurs préférés de l'argent seront-ils choisis parmi les β-dicétonates tels que le tétraméthylheptanedioate et les carboxylates d'argent. Un précurseur d'argent préféré entre tous est le pivalate d'argent qui permet de s'affranchir des problèmes de faible volatilité rencontrés avec des précurseurs tels que les carboxylates d'argent Ag(O₂CR) où R est un groupe alkyle de préférence de 3 à 7C, et également des problèmes de contamination généralement rencontrés avec les précurseurs organométalliques fluorés.

Avantageusement, selon l'invention, on utilise les mêmes précurseurs lors de l'étape a) (FSC) et lors de l'étape b) (CVD) ce qui conduit à la simplification des moyens de stockage et d'alimentation en réactifs.

A la sortie du dispositif de vaporisation, la composition, par exemple la solution vaporisée, contenant les précurseurs est introduite dans l'enceinte (1) déjà décrite qui contient le support sur lequel doit être effectué le dépôt d'une couche continue ou de nanoparticules dispersées.

Avant son arrivée dans le dispositif de vaporisation, la composition telle qu'une solution est généralement maintenue dans un réservoir (27) à la température ambiante.

La vaporisation de la composition de précurseur peut être effectuée à l'aide de divers dispositifs connus de l'homme du métier.

A titre d'exemple préféré, on peut citer le dispositif décrit dans Chem. Mat. 13, 3993 (2001), commercialisé par la société Jipelec sous le nom de « InJect, Système d'injection et d'évaporation de précurseurs liquides purs ou sous forme de solutions ». La température du support à revêtir qui se confond généralement avec la température dans l'enceinte de dépôt et que l'on peut définir comme étant la température de dépôt est selon l'invention de 100 à 800°C.

De préférence, on utilise une température relativement basse à savoir inférieure ou égale à 500°C, de préférence inférieure ou égale à 300°C, de préférence encore de 250 à 290°C, par exemple de 280°C.

Une telle température basse a l'avantage de permettre le dépôt des particules de métal ou d'alliage par exemple d'argent sur des substrats thermiquement fragiles ce qui n'aurait pas été possible par d'autres procédés opérant à des températures beaucoup plus élevées.

L'enceinte de dépôt pour cette étape b) du procédé est constituée par le réacteur, réservoir, fermé déjà décrit plus haut et utilisé lors de la première étape, mais dans lequel règne une atmosphère constituée par un gaz dit gaz réactionnel.

Ce gaz peut comprendre par exemple en majorité (en volume), un gaz réactif oxydant lorsque l'on souhaite notamment déposer des particules dispersées notamment d'argent. Mais le gaz réactionnel peut être aussi un gaz réducteur tel que H₂.

A l'intérieur de l'enceinte de dépôt (1) peut lors de cette étape de CVD régner la pression atmosphérique ou une pression inférieure à celle-ci (enceinte sous vide) par exemple une pression inférieure ou égale à 15 Torrs.

Le procédé selon l'invention peut avantageusement être réalisé avec une assistance plasma.

Les techniques d'assistance plasma sont complémentaires des procédés de dépôt chimique en phase vapeur à l'aide de précurseurs organométalliques dans le sens où elles autorisent également de faibles températures de réaction (techniques dites PA ou PE-CVD, à savoir « Plasma Assisted » ou « Plasma Enhanced Chemical Vapour Deposition »).

Le type d'excitation plasma peut être choisi par exemple parmi les excitations au plasma basse fréquence (BF), radiofréquence (RF) ou courant continu pulsé (DC pulsé).

L'assistance plasma permet d'offrir des possibilités supplémentaires de structuration de surfaces.

Un plasma froid peut donc éventuellement être ajouté autour du support. Lorsque le dépôt est effectué en présence de plasma, il est suffisant que le support, substrat, destiné à recevoir les nanoparticules de métal ou d'alliage de métaux, par exemple d'argent ou d'alliage d'argent soit maintenu à la même température qui règne dans l'évaporateur. En l'absence de plasma, il est nécessaire que ledit support soit à une température supérieure à celle de l'évaporateur, la différence de température étant au moins égale à 20°C, de préférence au moins égale à 50°C, afin d'éviter le dépôt de métal, par exemple d'argent, sur les parois du réacteur.

Lorsque l'on met en oeuvre un gaz qui est constitué en majorité par un gaz oxydant alors le changement des énergies de surface et de joint de grains induit par l'utilisation de ce gaz oxydant, permet d'élaborer des dépôts de nanoparticules de métal ou d'alliage de métaux, par exemple d'argent ou d'alliage d'argent, dispersées, par exemple des films discontinus, à des températures de dépôt relativement basses définies ci-dessus.

Comme on l'a déjà indiqué plus haut, le dépôt obtenu par le procédé selon l'invention peut dans ce cas être notamment défini comme un film poreux se présentant sous la forme d'îlots métalliques de taille nanométrique, c'est-à-dire généralement d'une dimension par exemple d'un diamètre de 1 à 400 nm, bien dispersées en surface du substrat, support que ce dernier soit dense ou poreux, ce qui leur confère une grande surface active, élément primordial pour des applications catalytiques par exemple.

La composition, la morphologie et en particulier la porosité des dépôts de nanoparticules de métal ou d'alliage de métaux, par exemple de nanoparticules d'argent ou de nanoparticules d'alliage d'argent, réalisées par le procédé de l'invention peut être réglée, ajustée, en agissant sur certains paramètres tels que la nature et le débit du gaz réactif, la quantité de précurseur, la température et la pression à la condition toutefois que dans ce cas le gaz en présence duquel est réalisé le dépôt contienne toujours une proportion majoritaire en volume de gaz oxydant, avec notamment un rapport de débits gaz oxydant/gaz inerte >1.

La mise en oeuvre du procédé de l'invention permet d'obtenir des nanoparticules à base de métal, par exemple à base d'argent, ayant une bonne adhérence sur les supports sur lesquels elles ont été déposées. La taille des nanoparticules varie en fonction des paramètres procédé et notamment en fonction du rapport de débits gaz oxydant/gaz inerte (toujours en restant avec ce rapport >1), du débit de précurseurs de métal et enfin du temps d'expérience. En général, les films sont non conducteurs et présentent visuellement un aspect mat.

Lorsque l'on utilise une quantité de gaz oxydant dans le gaz inférieure ou égale à 50% en volume, il est possible d'obtenir alors des films continus. De même, lorsque l'on met en oeuvre un gaz comprenant un gaz réducteur il est possible d'obtenir des dépôts continus ou discontinus.

Une installation qui convient particulièrement bien à la mise en oeuvre du procédé selon l'invention et qui est celle utilisée dans les exemples ci-dessous comprend un dispositif de vaporisation du type « InJect » cité plus haut commercialisé par la société JIPELEC qui est couplé à une enceinte de dépôt chimique en phase vapeur.

Le dispositif « InJect » comprend quatre parties principales :
- le ou les réservoirs (27) de stockage de la ou des solutions chimiques de précurseurs ; dans le cas où le film continu ou discontinu ou les nanoparticules sont constituées par un seul métal, un seul réservoir de stockage (27) est prévu ; dans le cas d'alliages dont la mise en solution des précurseurs organométalliques ne peut être effectuée dans un solvant commun, plusieurs réservoirs de stockage sont utilisés ;
- un ou plusieurs injecteur(s) (28), par exemple du type injecteur de moteur à essence ou diesel relié(s) par une ou plusieurs ligne(s), canalisation(s) (29) d'alimentation munies de filtre(s) (30) au(x) réservoir(s) de stockage(s) (27), de liquide et qui est piloté par un dispositif de commande électronique ;
- une ligne, canalisation d'alimentation en gaz vecteur (31) ou porteur inerte neutre (par exemple l'azote) aboutissant à l'injecteur (28) ;
- et un dispositif de vaporisation (32) (évaporateur).

L'enceinte de dépôt chimique en phase vapeur, qui contient le substrat à revêtir, comprend des moyens de chauffage, une alimentation en gaz réactif oxydant tel que l'oxygène introduit entre le système de vaporisation et l'entrée de la chambre de dépôt, et des moyens de pompage et de régulation de la pression, réduite si l'on opère sous vide. L'évaporateur est connecté à l'enceinte de dépôt chimique en phase vapeur par une canalisation qui est munie de moyens de chauffage, qui est maintenue à la même température que l'évaporateur, et qui est raccordée dans l'enceinte à un répartiteur de gaz (33).

L'enceinte de dépôt chimique en phase vapeur et le substrat à revêtir qui y est placé sont généralement maintenus dans cette étape b) à une température supérieure à celle de l'évaporateur afin de créer un gradient thermique positif. La solution chimique contenant le ou les précurseurs est introduite dans le réservoir maintenu sous pression à une pression par exemple de 1 bar ou 2 bars, puis envoyée à partir dudit réservoir, par l'intermédiaire du ou des injecteur(s) (par différence de pression) dans l'évaporateur qui est maintenu sous vide. Le débit d'injection est contrôlé en agissant sur la fréquence et la durée d'ouverture du ou des injecteur(s) que l'on peut considérer comme une microélectrovanne et qui est commandée par un ordinateur.

La réaction chimique se fait en présence d'un gaz réactionnel composé d'un gaz réactif, tel que O₂, H₂ ou CO₂ et sous une pression généralement inférieure ou égale à 2 000 Pa.

Notamment de par la nature chimique (au minimum un métal noble qui peut être le platine ou non noble comme l'argent et éventuellement plusieurs) et la morphologie (grand nombre de sites actifs de taille nanométrique très bien dispersés) des nanomatériaux selon l'invention (c'est-à-dire des substrats sur lesquels se trouvent dispersées des particules nanométriques par exemple d'argent ou d'alliage d'argent), ils apparaissent des candidats de choix dans les domaines de l'électronique, de l'optique et surtout de la catalyse par exemple pour la protection de l'environnement. A titre d'exemple, ils trouvent ainsi des applications directes pour l'oxydation en phase gazeuse (dépollution de l'air) et l'oxydation en phase aqueuse (dépollution de l'eau), mais ils peuvent également servir en tant que membranes pour la perméation à l'hydrogène (reformage des gaz pour les piles à combustible, hydrogénation/déshydrogénation) ou encore permettre de catalyser d'autres réactions dans le domaine des piles à combustible.

L'invention va maintenant être décrite en référence aux exemples suivants donnés à titre illustratif et non limitatif.

### Exemples

### Exemple 1

Dans cet exemple, on réalise le dépôt par imprégnation en milieu CO₂ supercritique d'une couche d'oxydes constituée de Al₂O₃, CeO₂, BaO, ZrO₂ sur un support céramique poreux constituée d'une mousse d'alumine-zircone (Al₂O₃/TiO₂) 20 ppi (« pores per inch »).

Le dépôt est réalisé à partir d'une solution chimique comprenant les précurseurs organométalliques dissous dans un solvant alcoolique (hexylène glycol ou isopropanol). La composition finale de la solution est présentée dans le tableau 1 suivant :

**TABLEAU 1**

| | **% en Masse** | **Précurseurs** |
|---|---|---|
| **Alumine Al₂O₃** | 12,9 | Tri-sec-butoxyde d'aluminium |
| **Zircone ZrO₂** | 2,2 | Propoxyde de zirconium |
| **Cérine CeO₂** | 2,4 | Acétylacétonate de cerium hydraté |
| **Oxyde de baryum BaO** | 1,4 | Acétylacétonate de baryum hydraté |
| **Solvant** | 81,1 | Hexylène glycol (2-methyl pentane-2,4-diol) Isopropanol (2-propanol) |

Les conditions de température et de pression sont fixées respectivement à 300°C et 30 MPa. Le temps de contact dans le réacteur entre les réactifs et le support est de 1 heure.

Dans le cas de cet essai, on obtient une imprégnation parfaite de la matrice macroporeuse et un dépôt de couche active homogène stable à haute température (figure 2).

### Exemple 2

Sur la couche d'oxydes (« wash coat ») préparée dans l'exemple 1, on peut réaliser le dépôt de nanoparticules de platine par dépôt chimique en phase vapeur CVD.

Pour les conditions de dépôt ci-dessous, les nanoparticules de platine sont réalisées sur substrat céramique poreux (mousse Alumine-Zircone 20ppi).

La solution chimique de dépôt comprend le précurseur organométallique du platine (acétylacétonate), dissout dans un solvant (acétylacétone).

Les températures de l'évaporateur et du substrat sont fixées respectivement à 220 et 340°C. Les autres conditions opératoires sont présentées dans le tableau 2 suivant :

**TABLEAU 2**

| | **Concentration (Mol/l)** | **Fréquence Injecteur (Hz)** | **Temps Ouverture Injecteur (ms)** | **Débits N₂/O₂ (cc)** | **Pression (Pascal)** | **Temps de dépôt (min)** |
|---|---|---|---|---|---|---|
| **Essai A** | 0,03 | 2 | 2 | 40/160 | 800 | 30 |
| **Essai B** | 0,03 | 2 | 2 | 40/160 | 800 | 20 |

Dans le cas des deux essais A et B, on obtient un dépôt cristallisé (voir figures 3 et 4 : la figure 3 correspondant à l'essai A et la figure 4 à l'essai B) de structure cubique, composé de nanoparticules de platine de 5 à 20 nm de diamètre non coalescées ; la densité des nanoparticules est dans ce cas proche de 10 ¹² cm⁻².

### Caractérisation des dépôts réalisés dans les Exemples 1 et 2

### • Caractérisation par microscopie électronique à balayage

On effectue la caractérisation par microscopie électronique à balayage tout d'abord de la couche d'oxydes préparée dans l'exemple 1 (figure 2).

On réalise ensuite la caractérisation par microscopie électronique à balayage du dépôt composé de nanoparticules de platine de l'exemple 2 (figures 3 et 4) .

### • Caractérisation par spectroscopie de diffraction des rayons X

On effectue la caractérisation par spectroscopie de diffraction des rayons X du dépôt de nanoparticules de platine de l'exemple 2 (Il s'agit du dépôt obtenu dans l'exemple 2 et sur les figures 3 et 4) : Figure 5.

### REFERENCES

[1] J. Jung, M. Perrut, Journal of Supercritical Fluids, 20 (2001), 179-219.
[2] F. Cansell, B. Chevalier, A. Demourgues, J. Etourneau, C. Even, V. Pessey, Journal of Materials Chemistry, 9 (1999), 67-75.
[3] McLaughlin, F. David, Skriba and C. Michael, United States Patent, 4,916,108, 1990.
[4] P. Serp, R. Feurer, R. Morancho, P. Kalck, Journal of Catalysis, 157 (1995), 294-300.

## Revendications

1. Procédé de préparation d'un substrat comprenant un support solide et plusieurs couches sur ledit support ;
- au moins une couche étant constituée par un film homogène et continu de particules d'un ou plusieurs oxyde(s) de métal, ou par des particules d'un ou plusieurs oxyde(s) de métal dispersées de manière homogène, sur le support ou sur une couche sous-jacente ;
- au moins une couche étant constituée par un film continu ou discontinu d'un ou plusieurs métal (métaux) ou d'un ou plusieurs alliage(s) de métaux, ou par des nanoparticules dispersées d'un ou plusieurs métal (métaux) ou d'un ou plusieurs alliage(s) de métaux, sur le support ou sur une couche sous jacente ;
ledit procédé comprenant les étapes suivantes :
a) - on imprègne le support solide ou une couche sous-jacente déjà déposée, chauffé, avec une solution de précurseurs du ou des oxyde (s) de métal dans un fluide supercritique, et on dépose un film homogène et continu des particules d'un ou plusieurs oxyde(s) de métal, ou des particules d'un ou plusieurs oxyde(s) de métal dispersées de manière homogène, sur le support ou sur la couche sous jacente ;
b) - on dépose un film continu ou discontinu d'un ou plusieurs métal (métaux) ou d'un ou plusieurs alliage(s) de métaux, ou des nanoparticules dispersées d'un ou plusieurs métal (métaux) ou d'un ou plusieurs alliage(s) de métaux sur le support ou sur une couche sous-jacente, par dépôt chimique en phase vapeur CVD, à partir d'un ou plusieurs précurseurs ;
les étapes a) et b) étant réalisées dans la même enceinte, même réacteur.

2. Procédé selon la revendication 1, dans lequel on réalise successivement une étape a) puis une étape b) ; ou bien on réalise successivement une étape b) puis une étape a).

3. Procédé selon l'une quelconque des revendications 1 à 2, dans lequel chacune des étapes a) ou b) ou la succession des étapes a) et b) ou b) et a) est répétée de 1 à 10 fois.

4. Procédé selon l'une quelconque des revendications précédentes, dans lequel une étape de synthèse organique réalisée par exemple par un procédé choisi parmi le procédé de polycondensation interfaciale, de polymérisation en émulsion et de polymérisation en milieu dispersé, est réalisée après une étape a) et/ou une étape b).

5. Procédé selon la revendication 1, dans lequelon on réalise les étapes successives suivantes :
a) - on imprègne le support solide chauffé avec une solution de précurseur (s) du ou des oxyde (s) de métal (métaux) dans un fluide supercritique et on dépose le film homogène et continu d'un ou plusieurs oxyde(s) de métal (métaux) sur ledit support ;
b) - on dépose des nanoparticules dispersées ou bien un film continu ou discontinu d'un ou plusieurs métal (métaux) ou d'un ou plusieurs alliage(s) de métaux sur ledit film homogène et continu, par dépôt chimique en phase vapeur CVD, à partir d'un ou plusieurs précurseurs.

6. Procédé selon la revendication 5, dans lequel une étape de synthèse organique réalisée par exemple par un procédé choisi parmi le procédé de polycondensation interfaciale, de polymérisation en émulsion et de polymérisation en milieu dispersé, est réalisée entre les étapes a) et b) et/ou après la succession des étapes a) et b).

7. Procédé selon la revendication 1, dans lequel ledit support solide est dense ou macroporeux.

8. Procédé selon l'une quelconque des revendications précédentes, dans lequel ledit support se présente sous la forme d'une mousse, notamment céramique, d'un nid d'abeille, d'un tube poreux, ou de granulés, de vermicelles, de billes ou de fibres.

9. Procédé selon la revendication 1, dans lequel ledit support solide est constitué par un ou plusieurs matériau(x) choisi(s) parmi les céramiques choisies de préférence parmi les céramiques oxydes simples ou mixtes, les nitrures et les carbures ; de préférence encore parmi la cordiérite (2Al₂O₃.2SiO₂.5MgO), le carbure de silicium (Sic), l'alumine/dioxyde de titane (Al₂O₃/TiO₂) de préférence sous la forme d'une mousse, l'alumine zircone (Al₂O₃/ZrO₂), le dioxyde de titane (TiO₂), l'alumine (Al₂O₃), la zircone (ZrO₂), et la silice (SiO₂) ; les métaux et alliages métalliques tels que l'acier ; les polymères ; les zéolithes ; le silicium ; le verre ; les tissus ; et les matériaux composites de ceux-ci.

10. Procédé selon l'une quelconque des revendications précédentes, dans lequel le ou les oxyde(s) de métal du film homogène et continu ou des particules dispersées de manière homogène sont choisis parmi les oxydes d'aluminium, cérium, baryum, zirconium, titane, vanadium, les oxydes mixtes de ces métaux, les mélanges de ces oxydes et oxydes mixtes, et les zéolithes.

11. Procédé selon l'une quelconque des revendications précédentes, dans lequel le ou les précurseurs du ou des oxyde(s) de métal sont choisis parmi les composés organométalliques tels que les alcoxydes métalliques, les β-dicétonates de métaux, les carboxylates de métaux ; et les sels métalliques.

12. Procédé selon l'une quelconque des revendications précédentes dans lequel le film homogène et continu a une épaisseur de 50 à 800 nm, de préférence de 80 à 150 nm.

13. Procédé selon l'une quelconque des revendications précédentes, dans lequel le fluide supercritique est choisi parmi le dioxyde de carbone, l'hexafluorure de soufre, l'oxyde nitreux, le protoxyde d'azote, les alcanes légers ayant, par exemple, de 1 à 6 atomes de carbone, tels que le méthane, l'éthane, le propane, le butane, l'isobutane, le pentane, l'hexane, les alcènes de 1 à 5C, comme l'éthylène et le propylène, ainsi que certains liquides organiques, comme le méthanol, l'éthanol, l'isopropanol et le butanol.

14. Procédé selon l'une quelconque des revendications précédentes, dans lequel dans l'étape a) la température et la pression du fluide sont respectivement comprises entre 100 et 600°C et entre 10 et 50 MPa.

15. Procédé selon l'une quelconque des revendications précédentes, dans lequel lors de l'étape a) le dépôt du film est réalisé par un procédé sol-gel, et/ou un procédé de décomposition thermique.

16. Procédé selon l'une quelconque des revendications précédentes, dans lequel à l'issue de l'étape a) et préalablement à l'étape b), on procède à une purge et à un nettoyage du réacteur par balayage du support avec le fluide supercritique.

17. Procédé selon l'une quelconque des revendications précédentes, dans lequel le ou les métaux qui sont déposés lors de l'étape b) sont choisis parmi les métaux dits « nobles » des colonnes VIIIB et IB du Tableau périodique, et les métaux non nobles à activité catalytique tels que l'argent, le rhodium, le platine, le palladium, l'iridium, le cuivre, le nickel, l'or ; et le ou les alliages qui sont déposés lors de l'étape b) sont choisis parmi les alliages de ces métaux entre eux et les alliages de ces métaux avec d'autres métaux, de préférence le ou lesdits alliage(s) est(sont) choisi(s) parmi les alliages des métaux des colonnes VIIIB et IB du Tableau périodique tels que Ag, Rh, Pt, Pd, Ir, Cu, Ni et Au entre eux.

18. Procédé selon l'une quelconque des revendications précédentes, dans lequel le dépôt de l'étape b) est réalisé en présence d'un gaz comprenant un gaz réactif oxydant choisi par exemple parmi l'oxygène, le dioxyde de carbone, l'ozone, le protoxyde d'azote N₂O, et leurs mélanges ou un gaz réactif réducteur choisi par exemple parmi l'hydrogène, l'ammoniac, les vapeurs d'alcool, les hydrocarbures et leurs mélanges, et de préférence le dépôt de l'étape b) est réalisé en présence d'un gaz comprenant plus de 50% en volume, de préférence plus de 70% du gaz réactif oxydant en volume de préférence encore 100% en volume du gaz réactif oxydant.

19. Procédé selon la revendication 18, dans lequel le gaz est constitué par un mélange du gaz réactif oxydant ou du gaz réactif réducteur et d'un gaz inerte choisi par exemple parmi l'argon, l'azote, l'hélium et leurs mélanges, et de préférence le gaz est constitué par un mélange d'un gaz oxydant et d'un gaz inerte et le rapport du débit du gaz oxydant sur le débit du gaz inerte est supérieur à 1.

20. Procédé selon l'une quelconque des revendications précédentes, dans lequel dans l'étape b), les précurseurs sont choisis parmi les composés organométalliques tels que les carboxylates de métaux, et les β-dicétonates de métaux, et les sels métalliques tels que les nitrates de métaux.

21. Procédé selon l'une quelconque des revendications précédentes, dans lequel lors de l'étape b) le ou les précurseurs notamment organométalliques sont mis en oeuvre sous la forme d'une solution de ces précurseurs dans un solvant organique, la concentration du ou des précurseur(s) dans la solution étant de préférence de 0,01 à 0,6 mol/l.

22. Procédé selon la revendication 21, dans lequel le solvant a une température d'évaporation inférieure à la température de décomposition du ou des précurseurs ; de préférence le solvant est choisi parmi les composés organiques liquides à température ambiante et jusqu'à 200°C dans les conditions normales de pression, tels que le mésitylène, le cyclohexane, le xylène, le toluène, le n-octane, l'isopropanol, le tétrahydrofuranne, l'acétylacétone, l'éthanol, l'eau ; et leurs mélanges.

23. Procédé selon l'une quelconque des revendications 21 et 22, dans lequel la solution comprend en outre une amine et/ou un nitrile.

24. Procédé selon l'une quelconque des revendications précédentes, dans lequel lors de l'étape b) le dépôt est réalisé : à une température du support inférieure ou égale à 500°C, de préférence inférieure ou égale à 300°C, de préférence encore de 250 à 290°C ; à pression atmosphérique ou bien sous vide, de préférence à une pression de 300 Pa à 1000 Pa ; et la durée du dépôt de l'étape b) est de 2 à 90 minutes, de préférence de 5 à 30 minutes.

25. Procédé selon l'une quelconque des revendications précédentes, dans lequel le dépôt est réalisé avec une assistance plasma.

26. Procédé selon l'une quelconque des revendications précédentes, dans lequel on utilise les mêmes précurseurs dans les étapes a) et b).

27. Procédé selon l'une quelconque des revendications précédentes, dans lequel lors de l'étape b) on dépose des nanoparticules dispersées, lesdites nanoparticules ayant de préférence une taille de 1 à 400 nm, de préférence encore de 1 à 100 nm, mieux de 5 à 50 nm.

28. Procédé selon la revendication 27, dans lequel les nanoparticules présentent une densité de 10 à 500 *µ*m⁻², de préférence de 50 à 200 *µ*m⁻².

29. Procédé selon l'une quelconque des revendications précédentes, dans lequel à l'issue de l'étape a) on réalise un traitement thermique par exemple à de 400 à 800°C.

30. Dispositif pour la mise en oeuvre du procédé selon la revendication 1, comprenant :
- une enceinte ou réacteur dans lequel est placé un support solide ;
- des moyens pour amener un fluide à l'état supercritique ;
- des moyens pour dissoudre un ou plusieurs précurseurs d'oxyde(s) de métal dans le fluide supercritique ;
- des moyens pour amener la solution de précurseurs du ou des oxyde (s) de métal dans le fluide supercritique dans le réacteur, en contact avec le support ou avec une couche déjà déposée ; moyennant quoi on dépose un film homogène et continu ou des particules dispersées de manière homogène d'un ou plusieurs oxyde(s) de métal sur ledit support ou ladite couche ;
- des moyens pour soutirer le fluide supercritique à l'issue du dépôt, à partir du réacteur, le détendre, séparer les précurseurs n'ayant pas réagi du fluide et recycler celui-ci vers le réacteur ;
- des moyens pour amener dans ledit réacteur un gaz contenant un ou plusieurs précurseur(s) d'un ou plusieurs métaux ou alliage de métaux ;
- des moyens pour chauffer le support ou une couche déjà déposée ;
- des moyens pour mettre le réacteur sous vide ou sous pression.

## Patentansprüche

1. Verfahren zur Herstellung eines einen festen Träger und mehrere Schichten auf dem genannten Träger umfassenden Substrats ;
- wobei wenigstens eine Schicht aus einem homogenen und kontinuierlichen Film aus Partikeln von einem oder mehreren Metalloxid(en), oder aus homogen verteilten Partikel von einem oder mehreren Metalloxid(en) besteht, auf dem Träger oder auf einer darunterliegenden Schicht ;
- wobei wenigstens eine Schicht aus einem kontinuierlichen oder diskontinuierlichen Film aus einem oder mehreren Metall(en) oder einer oder mehreren Metalllegierung(en), oder aus verteilten Nanopartikel von einem oder mehreren Metall(en) oder von einer oder mehreren Metalllegierung(en) besteht, auf dem Träger oder auf einer darunterliegenden Schicht;
wobei das Verfahren die folgenden Schritte umfasst:
a) - man imprägniert den festen Träger oder eine schon abgeschiedene darunterliegende Schicht, aufgeheizt, mit einer Lösung von Vorläufern von dem oder den Metalloxid(en) in einem superkritischen Fluid, und man scheidet einen homogenen und kontinuierlichen Film der Partikel von einem oder mehreren Metalloxid(en), oder homogen verteilten Partikel von einem oder mehreren Metalloxid(en) ab, auf dem Träger oder auf der darunterliegenden Schicht;
b) - man scheidet einen kontinuierlichen oder diskontinuierlichen Film aus einem oder mehreren Metall(en) oder einer oder mehreren Metalllegierung(en), oder verteilte Nanopartikel von einem oder mehreren Metall(en) oder von einer oder mehreren Metalllegierung(en) auf dem Träger oder auf einer darunterliegenden Schicht ab, durch chemische Gasphasenabscheidung CVD, ausgehend von einem oder mehreren Vorläufern,
wobei die Schritte a) und b) in demselben Behälter, demselben Reaktor durchgeführt werden.

2. Verfahren nach Anspruch 1, bei dem man nacheinander einen Schritt a), dann einen Schritt b) durchführt; oder auch nacheinander einen Schritt b), dann einen Schritt a) durchführt .

3. Verfahren nach einem der Ansprüche 1 bis 2, bei dem jeder der Schritte a) oder b) oder die Aufeinanderfolge der Schritte a) und b) oder b) und a) 1- bis 10-mal wiederholt wird .

4. Verfahren nach einem der vorhergehenden Ansprüche, bei dem einen Schritt der organischen Synthese, realisiert zum Beispiel durch ein Verfahren, ausgewählt unter Grenzflächenpolykondensations-, Emulsionspolymerisations- und Dispersionspolymerisationsverfahren, nach einem Schritt a) und/oder einem Schritt b) realisiert wird .

5. Verfahren nach Anspruch 1, bei dem man die folgenden aufeinanderfolgenden Schritte durchführt:
a) - man imprägniert den aufgeheizten festen Träger mit einer Lösung von Vorläufer(n) von dem (den) Oxid(en) von Metall(en) in einem superkritischen Fluid, und man scheidet den homogenen und kontinuierlichen Film von einem oder mehreren Metalloxid(en) auf dem genannten Träger ab ;
b) - man scheidet verteilte Nanopartikel oder einen kontinuierlichen oder diskontinuierlichen Film aus einem oder mehreren Metall(en) oder einer oder mehreren Legierung(en) von Metallen, auf dem genannten homogenen und kontinuierlichen Film durch chemische Gasphasenabscheidung CVD ab, ausgehend von einem oder mehreren Vorläufern.

6. Verfahren nach Anspruch 5, bei dem der Schritt der organischen Synthese, realisiert zum Beispiel durch ein Verfahren, ausgewählt unter Grenzflächenpolykondensations-, Emulsionspolymerisations- und Dispersionspolymerisationsverfahren, zwischen den Schritten a) und b) und/oder nach der Aufeinanderfolge der Schritte a) und b) durchgeführt wird.

7. Verfahren nach Anspruch 1, bei dem der genannte feste Träger dicht oder makroporös ist.

8. Verfahren nach einem der vorhergehenden Ansprüche, bei dem der genannte Träger sich schaumförmig, insbesondere in Form eines Keramikschaums, bienenwaben-, waffelmuster-, porenrohr-, granulat-, fadennudeln-, kugel- oder faserförmig präsentiert.

9. Verfahren nach Anspruch 1, bei dem der genannte feste Träger aus einem (oder mehreren) Material(ien) besteht, ausgewählt unter den Keramiken, bevorzugt ausgewählt unter den einfachen oder gemischten Oxidkeramiken, den Nitriden und den Karbiden ; bevorzugter unter dem Cordierit (2Al₂O₃.2SiO₂.5MgO), dem Siliciumkarbid (SiC), dem Aluminiumoxid/Titandioxid (Al₂O₃/TiO₂) vorzugsweise in Form eines Schaums, dem Aluminiumoxid-Zirkonoxid (Al₂O₃/ZrO₂), dem Titandioxid (TiO₂), dem Aluminiumoxid (Al₂O₃), dem Zirkonoxid (ZrO₂), und dem Siliciumdioxid (SiO₂) ; den Metallen und Metalllegierungen wie zum Beispiel dem Stahl ; den Polymeren ; den Zeolithen ; dem Silicium ; dem Glas ; den Geweben ; und den Verbundwerkstoffen aus diesen.

10. Verfahren nach einem der vorhergehenden Ansprüche, bei dem das oder die Metalloxid(e) des homogenen und kontinuierlichen Films oder der auf homogene Weise verteilten Partikeln ausgewählt werden unter den Aluminium-, Cerium-, Barium-, Zirkonium-, Titan-, Vanadium-Oxiden, den gemischten Oxiden von diesen Metallen, den Mischungen aus diesen Oxiden und gemischten Oxiden, und den Zeolithen.

11. Verfahren nach einem der vorhergehenden Ansprüche, bei dem der oder die Vorläufer von dem oder den Metalloxid(en) ausgewählt werden unter den organometallischen Verbindungen wie zum Beispiel Metallalkoxidverbindungen, Metall-β-Diketonate, Metallcarboxylate, und den Metallsalzen.

12. Verfahren nach einem der vorhergehenden Ansprüche, bei dem der homogene und kontinuierliche Film eine Dicke von 50 bis 800 nm, vorzugsweise von 80 bis 150 nm hat.

13. Verfahren nach einem der vorhergehenden Ansprüche, bei dem das superkritische Fluid ausgewählt wird unter dem Kohlenstoffdioxid, dem Schwefelhexafluorid, dem Stickstoffoxid, dem Lachgas (Distickstoffmonoxid), den leichten Alkanen mit, zum Beispiel, von 1 bis 6 Kohlenstoffatomen, wie etwa das Methan, das Ethan, das Propan, das Butan, das Isobutan, das Pentan, das Hexan, die Alkene von 1 bis 5C, wie das Ethylen und das Propylen, sowie bestimmte organische Flüssigkeiten wie das Methanol, das Ethanol, das Isopropanol und das Butanol.

14. Verfahren nach einem der vorhergehenden Ansprüche, bei dem in Schritt a) die Temperatur und der Druck des Fluids enthalten sind zwischen 100 und 600 °C beziehungsweise zwischen 10 und 50 MPa .

15. Verfahren nach einem der vorhergehenden Ansprüche, bei dem in Schritt a) das Abscheiden des Films durch ein Sol-Gel-Verfahren und/oder ein thermische Zersetzungsverfahren realisiert wird.

16. Verfahren nach einem der vorhergehenden Ansprüche, bei dem man am Ende von Schritt a) und vor dem Schritt b) den Reaktor entlüftet und reinigt indem man den Träger mit dem superkritischen Fluid spült.

17. Verfahren nach einem der vorhergehenden Ansprüche, bei dem das oder die in Schritt b) abgeschiedenen Metalle ausgewählt werden unter den so genannten Edelmetallen der Spalten VIIIB und IB des Periodensystems und den Nichtedelmetallen mit katalytischer Aktivität wie Silber, Rhodium, Platin, Palladium, Iridium, Kupfer, Nickel, Gold ; und die in Schritt b) abgeschiedene Legierung oder Legierungen ausgewählt werden unter den Legierungen dieser Metalle untereinander und den Legierungen dieser Metalle mit anderen Metallen, wobei diese Legierung oder Legierungen vorzugsweise ausgewählt werden unter den Legierungen der Metalle der Spalten VIIIB und IB des Periodensystems wie etwa Ag, Rh, Pt, Pd, Ir, Cu, Ni und Au untereinander.

18. Verfahren nach einem der vorhergehenden Ansprüche, bei dem die Abscheidung des Schritts b) unter Beteiligung eines Gases realisiert wird, das ein oxidierendes Reaktionsgas umfasst, ausgewählt zum Beispiel unter Sauerstoff, Kohlenstoffdioxid, Ozon, Distickstoffmonoxid N₂O und ihren Mischungen, oder ein reaktives Reduktionsgas, ausgewählt zum Beispiel unter Wasserstoff, Ammoniak, den Alkoholdämpfen, den Kohlenwasserstoffen und ihren Mischungen, und vorzugsweise die Abscheidung des Schritt b) unter Beteiligung eines Gases realisiert wird, das mehr als 50 Vol%, bevorzugter mehr als 70 Vol% und noch bevorzugter 100 Vol% oxidierendes Reaktionsgas umfasst.

19. Verfahren nach Anspruch 18, bei dem das Gas aus einer Mischung des oxidierenden Reaktionsgases oder des Reduktionsgases mit einem Inertgas, ausgewählt zum Beispiel unter Argon, Stickstoff, Helium und ihren Mischungen besteht, und vorzugsweise das Gas aus einer Mischung aus einem oxidierenden Gas mit einem inerten Gas besteht und das Durchflussverhältnis von oxidierendem Gas zu inertem Gas größer ist als 1 .

20. Verfahren nach einem der vorhergehenden Ansprüche, bei dem in Schritt b) die Vorläufer ausgewählt werden unter den organometallischen Verbindungen wie etwa den Metallcarboxylaten und den Metall-β-Diketonaten, und den Metallsalzen wie etwa den Metallnitraten.

21. Verfahren nach einem der vorhergehenden Ansprüche, bei dem in Schritt b) der oder die, insbesondere organometallischen, Vorläufer benutzt werden in Form einer Lösung dieser Vorläufer in einem organischen Lösungsmittel, wobei die Konzentration des oder der Vorläufer in dem Lösungsmittel vorzugsweise 0,01 bis 0,6 mol/l beträgt.

22. Verfahren nach Anspruch 21, bei dem das Lösungsmittel eine Verdampfungstemperatur hat, die niedriger ist als die Zersetzungstemperatur von dem oder den Vorläufern ; das Lösungsmittel wird vorzugsweise ausgewählt unter den organischen Verbindungen, die unter normalen Druckbedingungen bei Umgebungstemperatur und bis 200 °C flüssig sind, wie zum Beispiel das Mesitylen, das Cyclohexan, das Xylen, das Toluen, das n-Octan, das Isopropanol, das Tetrahydrofuran, das Acetylaceton, das Ethanol, das Wasser ; und ihre Mischungen .

23. Verfahren nach einem der Ansprüche 21 und 22, bei dem die Lösung außerdem ein Amin und/oder ein Nitril umfasst.

24. Verfahren nach einem der vorhergehenden Ansprüche, bei dem in Schritt b) die Abscheidung realisiert wird : bei einer Temperatur des Trägers unter oder gleich 500 C°, bevorzugter unter oder gleich 300 °C, noch bevorzugter von 250 bis 290 °C ; bei Umgebungsdruck oder auch unter Vakuum, vorzugsweise unter einem Druck von 300 Pa bis 1000 Pa ; und die Dauer der Abscheidung des Schritts b) beträgt 2 bis 90 Minuten, vorzugsweise 5 bis 30 Minuten.

25. Verfahren nach einem der vorhergehenden Ansprüche, bei dem die Abscheidung mit Plasmaunterstützung realisiert wird .

26. Verfahren nach einem der vorhergehenden Ansprüche, bei dem man in den Schritten a) und b) die gleichen Vorläufer benutzt.

27. Verfahren nach einem der vorhergehenden Ansprüche, bei dem man in Schritt b) verteilte Nanopartikel abscheidet, wobei die genannten Nanopartikel bevorzugt eine Größe von 1 bis 400 nm, bevorzugter von 1 bis 100 nm und noch besser von 5 bis 50 nm haben.

28. Verfahren nach Anspruch 27, bei dem die Nanopartikel eine Dichte von 10 bis 500 µm⁻², vorzugsweise von 50 bis 200 µm⁻² haben .

29. Verfahren nach einem der vorhergehenden Ansprüche, bei dem man am Ende des Schritts a) eine Wärmebehandlung zum Beispiel bei 400 bis 800 °C durchführt.

30. Vorrichtung für die Verwendung des Verfahrens nach Anspruch 1, umfassend :
- einen Behälter oder Reaktor, in dem ein fester Träger angeordnet wird ;
- Mittel für das Zuführen eines Fluids im superkritischen Zustand ;
- Mittel für das Lösen von einem oder mehreren Metalloxid(en)vorläufern in dem superkritischen Fluid ;
- Mittel um die Vorläuferlösung von dem (oder den) Metalloxid(en) in das superkritische Fluid in dem Reaktor einzubringen, in Kontakt mit dem Träger oder mit einer schon abgeschiedenen Schicht ; wodurch man einen homogenen und kontinuierlichen Film oder homogen verteilte Partikel von einem oder von mehreren Metalloxid(en) auf dem genannten Träger oder der genannten Schicht abscheidet;
- Mittel für das Entnehmen des superkritischen Fluid am Ende der Abscheidung, aus dem Reaktor, Expandieren dieses superkritischen Fluids, Trennen der nicht-reagierten Vorläufern von dem Fluid und Zurückführen des Fluids in den Reaktor ;
- Mittel um in den genannten Reaktor ein Gas einzubringen, das einen oder mehrere Vorläufer von Metall(en) oder Metalllegierung(en) umfasst;
- Mittel um den Träger oder eine schon abgeschiedene Schicht aufzuheizen ;
- Mittel um in dem Reaktor Vakuum oder Druck zu erzeugen.

## Claims

1. Method for preparing a substrate comprising a solid support and a plurality of layers on said support;
- at least one layer consisting of a uniform, homogeneous, and continuous film of particles of one or more metal oxide(s), or of uniformly, homogeneously, dispersed particles of one or more metal oxide(s), on the support or on an underlying layer;
- at least one layer consisting of a continuous or discontinuous film of one or more metal(s) or of one or more metal alloy(s), or of dispersed nanoparticles of one or more metal(s) or of one or more metal alloy(s), on the support or on an underlying layer;
said method comprising the following steps:
a) - impregnating the solid support or an already deposited underlying layer, heated, with a solution of precursors of the metal oxide or oxides in a supercritical fluid, and depositing a uniform, homogeneous, and continuous film of particles of one or more metal oxide(s), or uniformly, homogeneously, dispersed particles of one or more metal oxide(s), on the support or on the underlying layer
b) - depositing a continuous or discontinuous film of one or more metal(s) or of one or more metal alloy(s), or dispersed nanoparticles of one or more metal(s) or of one or more metal alloy(s), on the support or on an underlying layer, by chemical vapour deposition CVD, from one or more precursors;
the steps a) and b) being carried out in the same chamber, same reactor.

2. Method according to Claim 1, in which a step a) followed by a step b) are carried out in succession; or a step b) followed by a step a) are carried out in succession.

3. Method according to any one of Claims 1 to 2, in which each of the steps a) or b) or the succession of steps a) and b) or b) and a) is repeated from 1 to 10 times.

4. Method according to any one of the preceding claims, in which an organic synthesis step carried out for example by a method selected from the process of interfacial polycondensation, emulsion polymerisation and dispersion polymerisation is carried out after a step a) and/or a step b) .

5. Method according to Claim 1, in which the following successive steps are carried out:
a) - impregnating the heated solid support with a solution of precursor(s) of the metal(s) oxide(s) in a supercritical fluid and depositing the uniform, homogeneous, and continuous film of one or more metal(s) oxides(s) on said support;
b) - depositing dispersed nanoparticles or a continuous or discontinuous film of one or more metal(s) or of one or more metal alloy(s) on said uniform, homogeneous, and continuous film, by chemical vapour deposition CVD, from one or more precursors.

6. Method according to Claim 5, in which an organic synthesis carried out for example by a method selected from the process of interfacial polycondensation, emulsion polymerisation and dispersion polymerisation is carried out between the steps a) and b) and/or after the succession of steps a) and b).

7. Method according to Claim 1, in which said solid support is dense or macroporous.

8. Method according to any one of the preceding claims, in which said support is in the form of a foam, in particular a ceramic foam, a honeycomb, a porous tube, or of granules, of vermicelli, of beads or of fibres.

9. Method according to Claim 1, in which said solid support consists of one or more material(s) selected from ceramics preferably selected from single or mixed oxide ceramics, nitrides and carbides; more preferably from cordierite (2Al₂O₃.2SiO₂.5MgO), silicon carbide (SiC), alumina/titanium dioxide (Al₂O₃/TiO₂) preferably in the form of a foam, alumina/zirconia (Al₂O₃/ZrO₂), titanium dioxide (TiO₂), alumina (Al₂O₃), zirconia (ZrO₂), and silica (SiO₂); metals and metal alloys such as steel ; polymers ; zeolites ; silicon ; glass ; fabrics ; and composite materials thereof.

10. Method according to any one of the preceding claims, in which the metal oxide or oxides of the uniform and continuous film or of the uniformly dispersed particles are selected from oxides of aluminium, cerium, barium, zirconium, titanium, vanadium, mixed oxides of these metals, mixtures of these oxides and mixed oxides, and zeolites.

11. Method according to any one of the preceding claims, in which the precursor or precursors of the metal oxide or oxides are selected from organometallic compounds such as metal alkoxides, metal β-diketonates, metal carboxylates; and metal salts.

12. Method according to any one of the preceding claims, in which the uniform and continuous film has a thickness of 50 to 800 nm, preferably of 80 to 150 nm.

13. Method according to any one of the preceding claims, in which the supercritical fluid is selected from carbon dioxide, sulphur hexafluoride, nitrous oxide, dinitrogen monoxide, light alkanes having, for example, from 1 to 6 carbon atoms, such as methane, ethane, propane, butane, isobutane, pentane, hexane, alkenes from 1 to 5C, such as ethylene and propylene, and also certain organic liquids, such as methanol, ethanol, isopropanol and butanol.

14. Method according to any one of the preceding claims, in which in step a), the temperature and pressure of the fluid are respectively between 100 and 600°C and between 10 and 50 MPa.

15. Method according to any one of the preceding claims, in which during step a), the film is deposited by a sol-gel process and/or a thermal decomposition process.

16. Method according to any one of the preceding claims, in which on completion of step a) and prior to step b), the reactor is purged and cleaned by flushing the support with the supercritical fluid.

17. Method according to any one of the preceding claims, in which the metal or metals deposited during step b) are selected from metals called "noble" metals of columns VIIIB and IB of the Periodic Table of Elements, and non-noble metals having catalytic activity such as silver, rhodium, platinum, palladium, iridium, copper, nickel, and gold; and the alloy or alloys deposited during step b) are selected from alloys of these metals together and alloys of these metals with other metals; preferably said alloy(s) is(are) selected from alloys of metals of columns VIIIB and IB of the Periodic Table of Elements such as Ag, Rh, Pt, Pd, Ir, Cu, Ni and Au together..

18. Method according to any one of the preceding claims, in which the deposition in step b) is carried out in the presence of a gas comprising an oxidising reactive gas selected for example from oxygen, carbon dioxide, ozone, nitrous oxide N₂O and mixtures thereof or a reducing reactive gas selected for example from hydrogen, ammonia, alcohol vapours, hydrocarbons and mixtures thereof; and preferably the deposition in step b) is carried out in the presence of a gas comprising more than 50% by volume, preferably more than 70% of the oxidising reactive gas by volume, even more preferably 100% by volume of the oxidising reactive gas.

19. Method according to claim 18, in which the gas consists of a mixture of the oxidising reactive gas or of the reducing reactive gas and of an inert gas selected for example from argon, nitrogen, helium and mixtures thereof; and preferably the gas consists of a mixture of an oxidising gas and of an inert gas and the ratio of the flow rate of oxidising gas to the flow rate of inert gas is higher than 1.

20. Method according to any one of the preceding claims, in which in step b), the precursors are selected from organometallic compounds such as metal carboxylates, and metal β-diketonates; and metal salts such as metal nitrates.

21. Method according to any one of the preceding claims, in which during step b) the precursor or precursors in particular organometallic are used in the form of a solution of these precursors in an organic solvent; the concentration of the precursor or precursors in the solution being preferably 0.01 to 0.6 mol/l.

22. Method according to claim 21, in which the solvent has an evaporation temperature lower than the decomposition temperature of the precursor or precursors; preferably the solvent is selected from organic compounds that are liquid at ambient temperature and up to 200°C in standard pressure conditions, such as mesitylene, cyclohexane, xylene, toluene, n-octane, isopropanol, tetrahydrofuran, acetylacetone, ethanol, water and mixtures thereof.

23. Method according to any one of Claims 21 and 22, in which the solution further comprises an amine and/or a nitrile.

24. Method according to any one of the preceding claims, in which during step b), the deposition is carried out at a support temperature lower than or equal to 500°C, preferably lower than or equal to 300°C, even more preferably from 250 to 290°C; at atmospheric pressure or under vacuum, preferably at a pressure of 300 Pa to 1000 Pa; and the duration of the deposition in step b) is between 2 and 90 minutes, preferably between 5 and 30 minutes.

25. Method according to any one of the preceding claims, in which the deposition is carried out with plasma enhancement.

26. Method according to any one of the preceding claims, in which the same precursors are used in steps a) and b).

27. Method according to any one of the preceding claims, in which during step b), dispersed nanoparticles are deposited; said nanoparticles having preferably a size of 1 to 400 nm, more preferably of 1 to 100 nm, even more preferably from 5 to 50 nm.

28. Method according to claim 27, in which the nanoparticles have a density of 10 to 500 µm⁻², preferably 50 to 200 µm⁻².

29. Method according to any one of the preceding claims, in which on completion of step a), a heat treatment is carried out, for example at 400 to 800°C.

30. Device for implementing the method according to Claim 1, comprising:
- a chamber or reactor in which a solid support is placed;
- means for bringing the fluid to the supercritical state;
- means for dissolving one or more metal oxide(s) precursors in the supercritical fluid;
- means for conveying the solution of precursors of the metal oxide or oxides in the supercritical fluid to the reactor, in contact with the support or with an already deposited layer; whereby a uniform, homogeneous, and continuous film or uniformly, homogeneously, dispersed particles of one or more metal oxide(s) are deposited on said support or said layer;
- means for withdrawing the supercritical fluid on completion of the deposition, from the reactor, for expanding it, for separating the unreacted precursors from the fluid and recycling said fluid to the reactor;
- means for conveying to said reactor a gas containing one or more precursor(s) of one or more metal(s) or metal alloy(s);
- means for heating the support or an already deposited layer;
- means for placing the reactor under vacuum or under pressure.
